Europäisches Patentamt

(19) European Patent Office

Office européen des brevets

(11) Publication number: **0 011 975**
**B1**

(12) **EUROPEAN PATENT SPECIFICATION**

(45) Date of publication of patent specification: **26.09.84**

(21) Application number: **79302623.8**

(22) Date of filing: **19.11.79**

(51) Int. Cl.³: **G 11 C 11/34**

(54) **A semiconductor element in an EPROM bootstrap circuit.**

(30) Priority: **27.11.78 JP 146248/78**

(43) Date of publication of application:
**11.06.80 Bulletin 80/12**

(45) Publication of the grant of the patent:
**26.09.84 Bulletin 84/39**

(84) Designated Contracting States:
**DE FR GB NL**

(56) References cited:
**DE-A-2 545 450**
**DE-A-2 706 205**
**US-A-3 889 135**

(73) Proprietor: **FUJITSU LIMITED**
**1015, Kamikodanaka Nakahara-ku**
**Kawasaki-shi Kanagawa 211 (JP)**

(72) Inventor: **Higuchi, Mitsuo**
**5-13 Yutenji 2-chome**
**Meguro-ku Tokyo 153 (JP)**
Inventor: **Miyasaka, Kiyoshi**
**577-45, Iijima-cho, Totsuka-ku**
**Yokohama-shi Kanagawa 244 (JP)**

(74) Representative: **Rackham, Stephen Neil et al**
**GILL JENNINGS & EVERY 53-64 Chancery Lane**
**London WC2A 1HN (GB)**

Courier Press, Leamington Spa, England.

## Description

This invention relates to a semiconductor element forming at least part of a bootstrap circuit in an Erasable and Programmable Read-Only Memory semiconductor device included in a package having a window for receiving light (hereinafter referred to as an EPROM device). The memory of such a device can be erased by ultraviolet light and then be reprogrammed bit by bit with appropriate voltage pulses.

In general, an EPROM is provided with a means for producing a high-voltage and high power-signal when the EPROM is reprogrammed and typically such means is formed by a bootstrap circuit. A package for accommodating a chip on which an EPROM is formed includes a window to enable ultraviolet light to contact the chip. To erase the content of the EPROM, the entire chip is exposed to strong ultraviolet light from an ultraviolet light generating unit through the window of the package. The entire package may be put into a box so that the package is not exposed to any kind of light. However, the EPROM is typically reprogrammed in a room with normal lighting without its window being covered since the intensity of the ultraviolet component of the light in a room is so small that the EPROM is not erased. The programmed EPROM is then tested and, if satisfactory, usually has its window covered. If unsatisfactory it is erased again and reprogrammed.

A bootstrap circuit including a capacitor is used in an EPROM to feed a high voltage and high power signal used to program it. The applicants have discovered that when an EPROM is reprogrammed in a light room, a connection node of the capacitor and a MIS (Metal-Insulator-Semiconductor) field effect transistor is exposed to light and the light penetrates into a p-n junction portion formed by a substrate of one conductivity type and the source or drain region of another conductivity type of the MIS field effect transistor. As a result of this light penetration the number of available charge carriers increases and thus the charge on the source or drain region decreases and, accordingly, the charge of the capacitor also decreases, since one of the conducting surfaces of the capacitor is connected to the source or drain region. To enable the EPROM to be programmed effectively, the difference potential across the capacitor must be maintained at a high level for as long as possible. However, since this difference in potential falls, failures in writing new data into the EPROM occur when it is exposed to normal light in a room during programming.

According to a first aspect of the present invention there is provided a semiconductor element forming a bootstrap circuit in an erasable and programmable read-only memory semiconductor device included in a package having a window for receiving light comprising first and second MIS field effect transistors connected in series between a power supply line and an earth line; the second MIS field effect transistor arranged to receive a first input signal; third and fourth MIS field effect transistors connected between the power supply line and the earth line, the fourth MIS field effect transistor arranged to receive a second input signal; a capacitor connected between the gate and source of the third MIS field effect transistor; and a fifth MIS field effect transistor connected between first and second nodes, the first node connecting the first and second MIS field effect transistors and the second node being connected to the gate of the third MIS transistor and to the capacitor and hence coupled to the third and fourth MIS field effect transistors and the output of the element, characterised in that the source or drain of the fifth MIS field effect transistor which is connected to the second node and hence is connected to the capacitor, is shielded by a cover which prevents light from reaching a p-n junction formed between the source or drain and the substrate whilst allowing light to fall on other parts of the device.

According to a second aspect of the present invention there is provided a semiconductor element forming at least a part of a bootstrap circuit in an erasable and programmable read-only memory semiconductor device included in a package having a window for receiving light comprising a semiconductor substrate of a first conductivity type; first, second and third regions of a second conductivity type formed in the substrate; a first insulating layer formed on the substrate and arranged between the first and second regions; a second insulating layer formed on the substrate and arranged adjacent the third region; a first electrically conducting layer formed on the first insulating layer so that a MIS transistor is formed by the first electrically conducting layer, the first insulating layer and the first and second regions; and a second electrically conducting layer formed on the second insulating layer so that a capacitor is formed having a first surface provided by the second electrically conducting layer and a second surface provided by the substrate adjacent the third region, the first and second surfaces being separated by the second insulating layer, and the second electrically conducting layer being electrically connected to the second region, characterised in that an opaque layer is provided over the second region to prevent light from penetrating into a junction formed between the second region and the substrate whilst allowing light to fall on other parts of the device.

The opaque layer may be formed by a third conducting layer connecting the second region and the second layer.

If the semiconductor device including a semiconductor element in accordance with this invention is placed in a light room, the charge on the second region is not decreased, since this region is covered by an opaque covering layer, which prevents the light penetrating into the p-n junction portion. Therefore, the charge of the capacitor which is connected to the second region is maintained. This results in the difference potential of the capacitor being maintained at a definite value when the MIS transistor is nonconductive, which ensures that new data is written correctly into the EPROM even when it is exposed to light in a room.

However, since the cover is local in extent and is located only in the required region, the EPROM can be erased by application of ultraviolet light.

Particular embodiments of elements in accordance with this invention will now be described and contrasted with the prior art with reference to the accompanying drawings; in which:—

Figure 1 is a circuit diagram illustrating a bootstrap circuit form by MIS field effect transistors;

Figure 2 is a graph illustrating the operation of the bootstrap circuit;

Figure 3 is a plan of a first embodiment of the semiconductor element of the present invention;

Figure 4 is a cross-section taken along the lines IV—IV of Figure 3;

Figure 5 is a cross-section taken along the lines V—V of Figure 3;

Figure 6A is a cross-section taken along the lines VI—VI of Figure 3;

Figure 6B is a cross-section of a modification of the embodiment shown in Figure 6A;

Figure 7 is a plan of a second embodiment of the semiconductor element of the present invention;

Figure 8 is a cross-section taken along the lines VIII—VIII of Figure 7;

Figure 9 is a cross-section taken along the lines IX—IX of Figure 7;

Figure 10 is a plan of a third embodiment of the semiconductor element of the present invention;

Figure 11 is a cross-section taken along the lines XI—XI of Figure 10; and,

Figure 12 is a cross-section taken along the lines XII—XII of Figure 10.

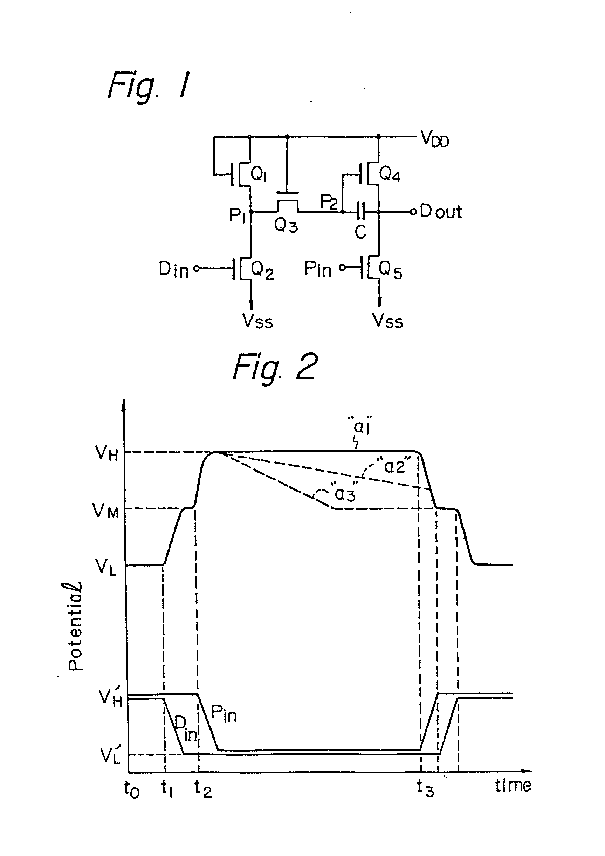

Figure 1 illustrates a bootstrap circuit formed by MIS transistors and is similar to such a circuit shown and described in IBM Technical Disclosure Bulletin Vol 14 No 4 September 1971.

The bootstrap circuit comprises five MIS field effect transistors such as n-channel type MOS (Metal Oxide Semiconductor) transistors $Q_1$ to $Q_5$ and a capacitor C arranged between the gate and the source of the MOS transistor $Q_4$. The drain and the gate of the MOS transistor $Q_1$ are connected to a power supply line $V_{DD}$ whose potential is, for example, 25 volts, while the source of the transistor $Q_1$ is connected to the drains of the MOS transistors $Q_2$ and $Q_3$. The

gate of the MOS transistor $Q_2$ is connected to a control signal input terminal $D_{in}$, while the source of the MOS transistor $Q_2$ is connected to another power supply line $V_{SS}$ (earth line) whose potential is, for example, 0 volt. The gate of the MOS transistor $Q_3$ is connected to the power supply line $V_{DD}$, while the source of the MOS transistor $Q_3$ is connected to the gate of the MOS transistor $Q_4$. The source of the MOS transistor $Q_4$ and the drain of the MOS transistor $Q_5$ are connected to an output terminal $D_{out}$, while the gate of the MOS transistor $Q_5$ is connected to a program signal input terminal $P_{in}$. It should be noted that the MOS transistors $Q_1$ and $Q_4$ serve as load transistors, while the MOS transistors $Q_2$ and $Q_5$ serve as input transistors. In addition, the MOS transistor $Q_3$ is used to charge the capacitor C and maintain the charge stored in the capacitor C. The bootstrap circuit of Fig. 1 is operated as follows.

Fig. 2 is graphs for explaining the operation of the bootstrap circuit of Fig. 1. In Fig. 2, upper curves "a1", "a2" and "a3" show the change of the potential at node $P_2$ of Fig. 1 and lower curves show the potentials of the terminals $D_{in}$ and $P_{in}$. As illustrated in Fig. 2, at time $t_0$, the potentials of the terminals $D_{in}$ and $P_{in}$ remain at a high voltage $V_H'$ which is higher than a common threshold voltage of all the MOS transistors (hereinafter referred as to $V_{th}$). In this case, since both of the MOS transistors $Q_1$ and $Q_2$ are conductive, the potential at node $P_1$ becomes lower than $V_{th}$, if the resistivity of the MOS transistor $Q_2$ is much smaller than that of the MOS transistor $Q_1$. In addition, since the MOS transistor $Q_3$ is conductive, the potential at node $P_2$ is also lower than $V_{th}$ and the MOS transistor $Q_4$ is nonconductive. The value of these potentials is defined as $V_L$ as illustrated in Fig. 2. In addition, since the potential at the input terminal $P_{in}$ is also $V_H'$, the MOS transistor $Q_5$ is conductive. Therefore, the potential at the output terminal $D_{out}$ also becomes $V_{SS}$ (here $V_{SS}$ and $V_{DD}$ are also defined as the voltages of the supply line $V_{SS}$ and $V_{DD}$, respectively).

Next, as illustrated in Fig. 2, at time $t_1$, when the potential at the input terminal $D_{in}$ is changed from the voltage $V_H'$ to a voltage $V_L'$ which is lower than $V_{th}$, the MOS transistor $Q_2$ cuts off. After that, the potential at node $P_1$ becomes high and, accordingly, the potential at node $P_2$ becomes high since the MOS transistor $Q_3$ is conductive. Finally, both of the potentials at nodes $P_1$ and $P_2$ reach a voltage

$$V_M (= V_{DD} - V_{th}).$$

On the other hand, the MOS transistors $Q_4$ and $Q_5$ are conductive. Since the resistivity of the MOS transistor $Q_5$ is much smaller than that of the MOS transistor $Q_4$, the potential at the output terminal $D_{out}$ remains low. Therefore, the difference in potential between the capacitor C becomes nearly $V_M$.

Next, as illustrated in Fig. 2, at time $t_2$, when

the potential at the input terminal $P_{in}$ is changed from the voltage $V'_H$ to the voltage $V'_L$, the MOS transistor $Q_5$ cuts off. As a result, the potential at the output terminal $D_{out}$ becomes high and, in addition, the potential at node $P_2$ becomes high, since the capacitor C is arranged between the terminal $D_{out}$ and the node $P_2$, and the MOS transistor $Q_3$ is nonconductive. Finally, the potential at the output terminal $D_{out}$ becomes $V_{DD}$ and, at this time, the potential at node $P_2$ becomes $V_H$ (this value is determined by the capacitor C and the capacitance formed between the node $P_2$ and the substrate). Therefore, if the potential at node $P_2$ is maintained at $V_H$ until time $t_3$, as illustrated in Fig. 2 (line "a1"), the potential at the output terminal $D_{out}$ is also maintained at $V_{DD}$ until time $t_3$.

The above-mentioned bootstrap circuit is manufactured in a body with an EPROM which can be erased by ultraviolet light by using semiconductor technology, especially, MOS technology. Since the package of the EPROM has a window for receiving the ultraviolet light, the bootstrap circuit may be also exposed to the light in a light room. Therefore, during reprogramming, light is penetrated into a p-n junction portion of the source of the MOS transistor $Q_3$. The charge stored in the source may be decreased and the potential at node $P_2$ may become low, as illustrated in Fig. 2 (dotted lines "a2" or "a3"). Following this, the conductance of the MOS transistor $Q_4$ becomes small, and the potential at the output $D_{out}$ also may become lower than $V_{DD}$. Therefore, by an output signal from the bootstrap circuit, reprogramming cannot be effected. In order to prevent light from penetrating into the p-n junction portion at node $P_2$, the bootstrap circuit manufactured by MOS technology according to the present invention, is provided with a cover, such as a metal layer overlying the node $P_2$, i.e., the source of the MOS transistor $Q_3$.

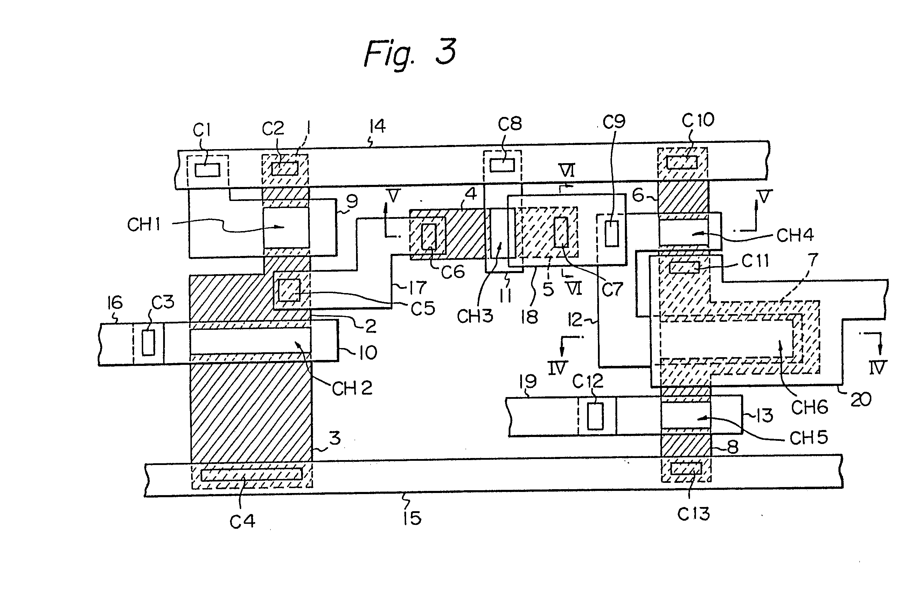

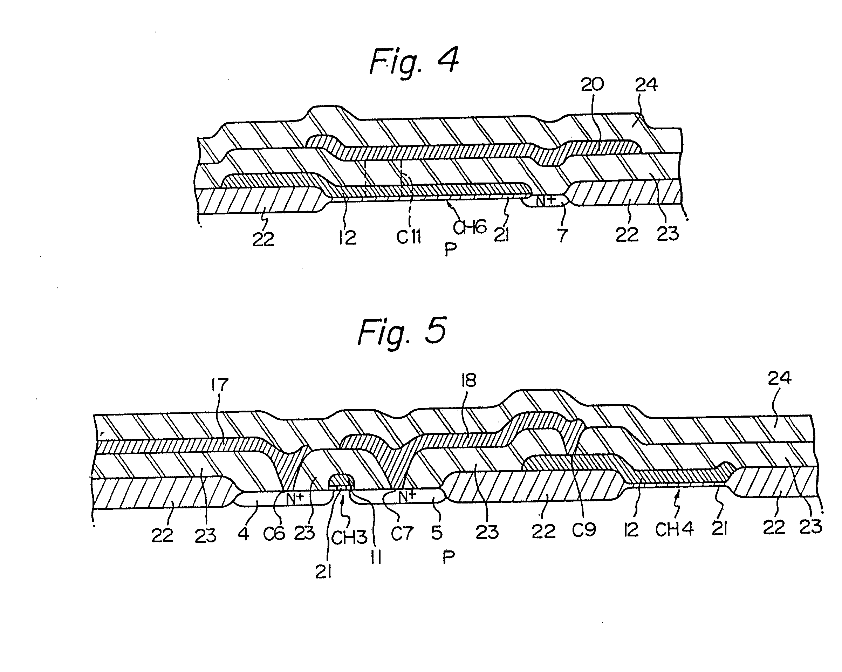

Fig. 3 is a plan view illustrating a first embodiment of the semiconductor device of the present invention. The substrate such as a p-type silicon (Si) substrate is initially prepared. On the substrate, a thin silicon dioxide ($SiO_2$) layer 21 and a thick silicon dioxide layer 22 (shown not in Fig. 3, but in Fig. 4) are formed. The area where a thin oxide layer is formed is carred an "active area", while the area where a thick oxide layer is formed is called "field area". The active area is divided into channel areas CH1, CH2 ..., CH6 and $n^+$ type regions 1 through 8, wherein the areas CH1, CH2, ..., CH5 correspond to the channel region of the MOS transistors $Q_1$, $Q_2$, ..., $Q_5$ and the area CH6 corresponds to the capacitor C. The $n^+$ type regions are formed in the substrate after the thin oxide layers thereon are removed. In addition, first electrically conductive layers 9 through 13 made of, for example, polycrystalline silicon overlying the channel areas CH1, CH2, ..., CH6 are deposited. Next, second electrically conductive layers 14 through 20 which are made of, for example, aluminium, are deposited. The layers 14 and 15 correspond to the power supply lines $V_{DD}$ and $V_{SS}$ (Fig. 1), respectively, and the layers 16, 19 and 20 are connected to the control signal input terminal $D_{in}$, the program signal input terminal $P_{in}$ and the output terminal $D_{out}$ (Fig. 1), respectively. Between the two kinds of electrically conductive layers, an insulating layer 23 (shown not in Fig. 3, but in Fig. 4) made of, for example, Phosphosilicate Glass (hereinafter referred as to PSG) or silicon dioxide ($SiO_2$) is provided. In addition, over the second electrically conductive layers, another insulating layer 24 (see Fig. 4) which is, for example, made of PSG is also provided. C1 through C13 are contacts for interconnecting electrically conductive layers, and $n^+$ type regions. It should be noted that the electrically conductive layer 18 overlies the $n^+$ type source region 5. The area of the layer 18 is larger than that of the $n^+$ type source region 5. Therefore, most of the light toward the $n^+$ type source region 5 is reflected at the upper surface of the conductive layer 18 so that the light hardly penetrates into the p-n junction portion formed by the $n^+$ type source region and p-type substrate. As a result, when the MOS transistor $Q_3$ (Fig. 1) whose gate corresponds to the area CH3 is nonconductive, the charge of the $n^+$ type source region 5 may not decrease and the charge of the capacitor C also may not decrease.

Fig. 4 is a cross-sectional view taken along the lines IV—IV of Fig. 3 showing the structure of the capacitor C. The capacitor C consists of two conducting surfaces separated by the thin oxide layer 21. One of the two surfaces is in contact with the electrically conductive layer 12, while the other is adjacent to the $n^+$ type region 7 which is connected to the electrically conductive layer 20 through the contact C11. Since the thin oxide layer 21 is, for example, a thickness of 50—80 nm (500~800 Å), the capacity of the capacitor C is very large, even if the area CH6 is small.

Fig. 5 is a cross-sectional view taken along the lines V—V of Fig. 3, showing the structure of the MOS transistors $Q_3$ and $Q_4$. The MOS transistor $Q_3$ is composed of an electrically conductive layer 11 which is, for example, made of polycrystalline silicon, as a gate electrode, a thin oxide layer 21, and two $n^+$ type regions 4 and 5, as a drain and a source thereof, respectively. The $n^+$ type drain region 4 is connected to an electrically conductive layer 17 at a contact C6, while the $n^+$ type source region 5 is connected to an electrically conductive layer 18 at a contact C7. The conductive layer 18 is connected to an electrically conductive layer 12, which serves as a gate electrode of the MOS transistor $Q_4$ and is also connected to a capacitor C (Fig. 1). As can be understood from Fig. 5, the conductive layer 17 covers the $n^+$ type drain region 4 incompletely, while the conductive layer 18 covers the whole of the $n^+$ type source region 5 with the insulating layer in-between. Therefore, it is hard for light to penetrate into the n⁺ type source region 5 through the insulating layers 23 and 24.

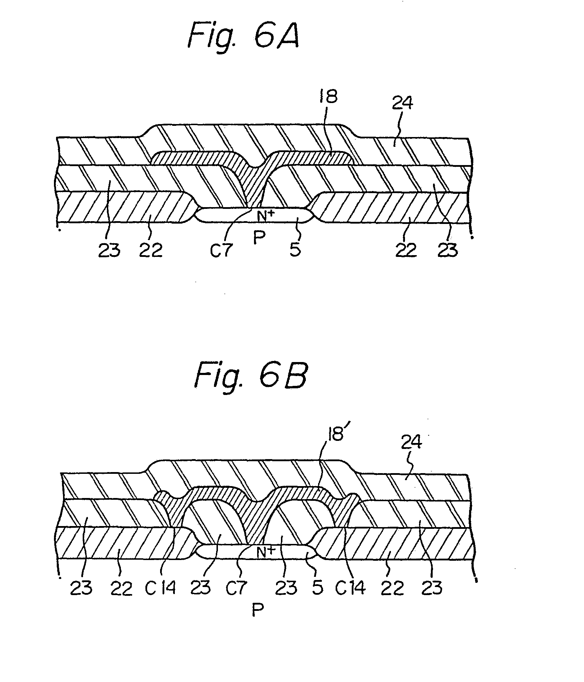

Fig. 6A is a cross-sectional view taken along the lines VI—VI of Fig. 3, showing the structure of the MOS transistor Q₃. As can be easily understood, the electrically conductive layer 18 covers the whole of the n⁺ type source region 5 with the insulating layer in-between.

Fig. 6B is a modification of Fig. 6A, showing the structure of the MOS transistor Q₃. The electrically conductive layer 18′ is a modification type of the electrically conductive layer 18. The conductive layer 18′ is also connected non-electrically to a thick oxide layer 22 at a contact C14. The contact C14 is placed in the neighbourhood of the n⁺ type source region 5. Therefore, the penetration of light into the n⁺ type source region 5 can be blocked by the conductive layer 18′ more reliably, than with the conductive layer 18 of Fig. 6A.

In Fig. 6B, it should be noted that, in the manufacturing process of the semiconductor device, both of the contacts C7 and C14 are formed in the insulating layer 23 in one step. However, an aperture can be formed at the same position as the contact C14 and the depth of the aperture can be about half of the thickness of the insulating layer 23. After that, the electrically conductive layer 18′ can be formed on the aperture. In this case, the penetration of light into the n⁺ type source region 5 can be also blocked by the conductive layer 18′ more reliably, as compared with the conductive layer 18 of Fig. 6A.

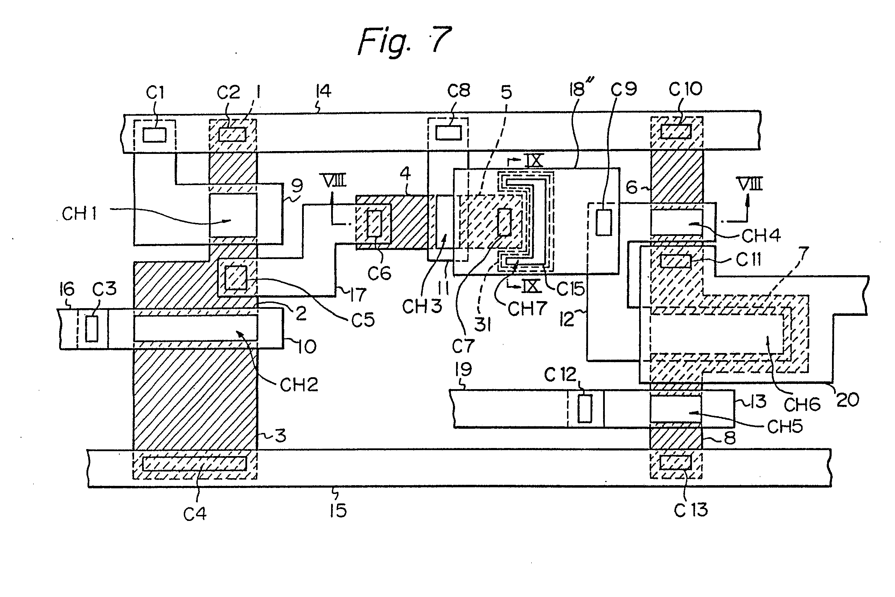

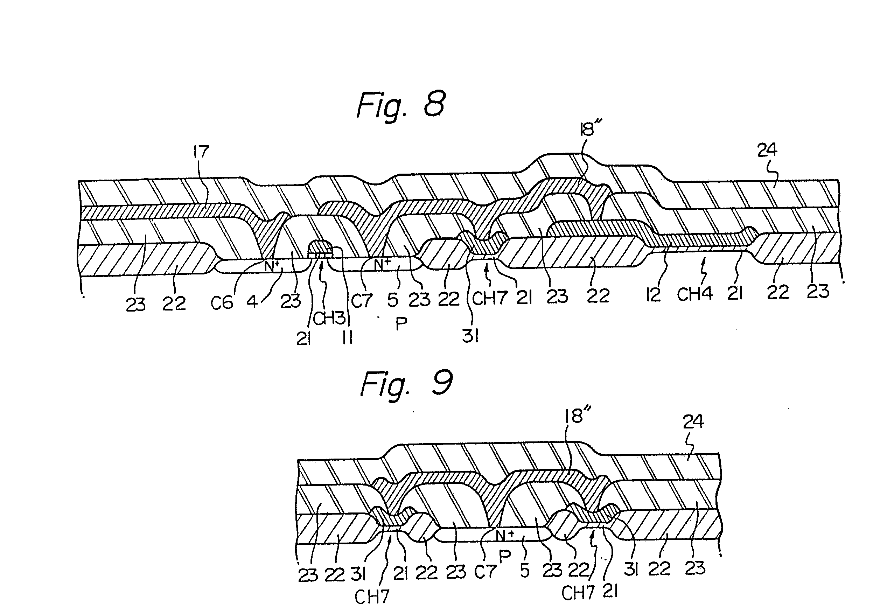

Fig. 7 is a plan view illustrating a second embodiment of the semiconductor device of the present invention. And Figs. 8 and 9 are cross-sectional views taken along the lines VIII—VIII and the lines IX—IX, respectively. The elements illustrated in Fig. 7 which are identical with those of Fig. 3 are given the same reference numerals as used in Fig. 3. In Fig. 7, a channel area CH7 which is placed in the neighbourhood of the n⁺ type source region 5 is provided (see also Figs. 8 and 9). In this case, the channel area CH7 does not form a gate of a MOS transistor, since the area CH7 is surrounded by the thick oxide layer 22. On the channel area CH7, an electrically conductive layer 31 which is, for example, made of polycrystalline silicon, is formed. In addition, an electrically conductive layer 18″, which is similar to the electrically conductive layer 18′ of Fig. 6B, is formed. Therefore, the penetration of light into the n⁺ type source region 5 is blocked more reliably, as compared with the conductive layer 18 of Fig. 6A.

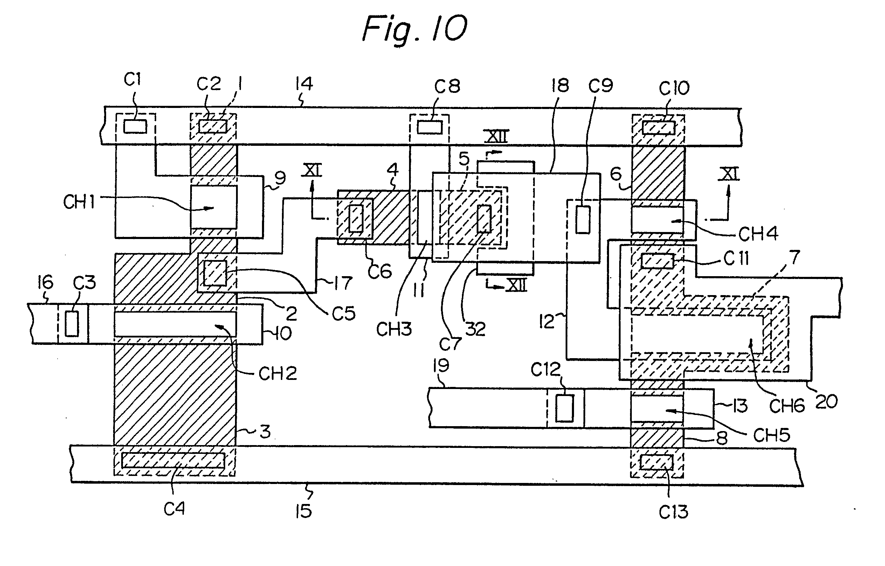

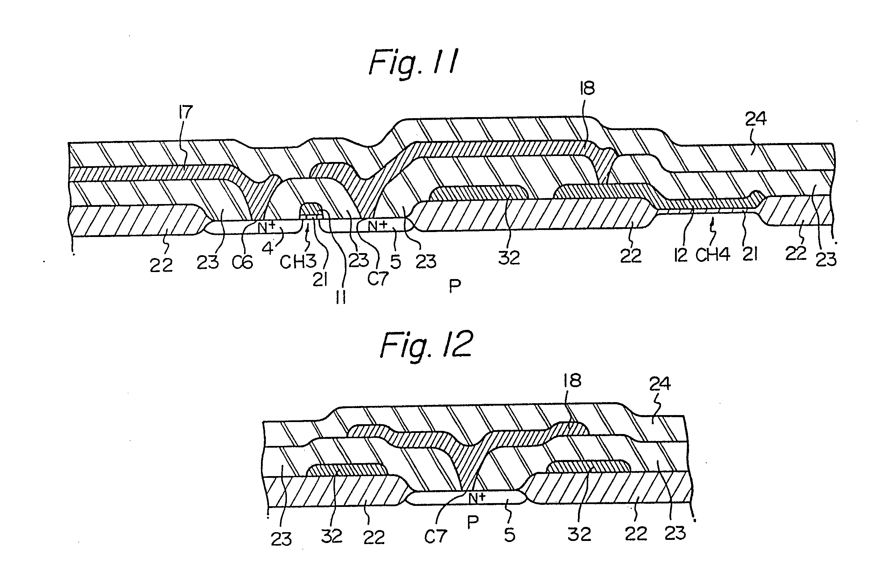

Fig. 10 is a plan view illustrating a third embodiment of the semiconductor device of the present invention. And Figs. 11 and 12 are cross-sectional views taken along the lines XI—XI and the lines XII—XII, respectively, of Fig. 10. The elements illustrated in Fig. 10 which are identical with those of Fig. 3 are given the same reference numerals as used in Fig. 3. In Fig. 10, an electrically conductive layer 32 which is, for example, made of polycrystalline silicon is provided on the thick oxide layer 22 (see also Figs. 11 and 12) and is placed in the neighbourhood of the n⁺ type source region 5. In general, the reflection factor of polycrystalline silicon material is greater than that of silicon dioxide material. Therefore, most of the light from outside which comes into the insulating layer 23 in the neighbourhood of the conductive layer 18 is reflected at the upper surface of the conductive layer 18, while the remainder is reflected at the surfaces of the conductive layer 32 and at the surface of the substrate and said remainder is attenuated. Therefore, the penetration of light into the n⁺ type source region 5 is blocked more reliably, as compared with the conductive layer 18 of Fig. 6A.

Actually, a bootstrap circuit device including a structure illustrated in Figs. 7, 8 and 9 is manufactured in the following conditions.

| | |
|---|---|
| Concentration of a p-type substrate | ~10¹⁵/cm³ |
| Concentration of n⁺-type region 5 | ~10²²/cm³ |
| Depth of n⁺-type region 5 | 0.8~1.0 μm |
| Area of n⁺-type region 5 | ~1.0 μm☐ |
| Thickness of thick insulating layer 22 (SiO₂) | ~800 nm (8,000 Å) |
| Thickness of thin insulating layer 21 (SiO₂) | 80—100 nm (800~—1,000 Å) |
| Thickness of electrically conductive layer 31 (Polycrystalline silicon) | ~400 nm (4,000 Å) |
| Thickness of electrically conductive layer 18″ (Al) | 1~1.5 μm |
| Distance between n⁺-type region 5 and a channel area CH7 | ~10 μm |

In above-mentioned bootstrap circuit device, the time which takes for the potential (see Fig. 2) to change from $V_H$ to $V_M$ is about 100 ms (in the prior art device, the time is on the order of $10^2$ μs). This is helpful for increasing the characteristics of the device, since the frequency of writing pulses from a EPROM is, for example, about 50 ms.

As has been mentioned above, the semiconductor device may be manufactured by using n-type MOS technology. However, it should be noted that the semiconductor device can be also manufactured by using p-type MOS technology. In this case, the semiconductor device comprises a n-type substrate and p⁺ type regions formed in the substrate, whereby p-channel type MOS transistors are formed.

In addition, in the above-mentioned embodiments, gate electrodes of the MOS transistors are made of polycrystalline silicon. However, it should be noted that the gate electrodes can be also made of metals such as molybdenum (Mo) or tungsten (W).

Furthermore, in order to ensure more reliable isolation between the MOS transistors and between the MOS transistor and the capacitor, high density regions of the same conductivity type as that of the substrate, which are called "channel cut regions" or "channel stoppers", can be also formed between the thick insulating layer and the substrate. In this case, the high density regions are manufactured by ion-implantation technology or diffusion technology.

As explained hereinbefore, the semiconductor device in bootstrap circuits included in an EPROM which can be erased by ultraviolet light according to the present invention has an advantage in that the EPROM can be reprogrammed effectively even in a light room, because the light penetrating into the node of the capacitor is blocked and the charge of the capacitor may not be decreased in the light room.

## Claims

1. A semiconductor element forming a bootstrap circuit in an erasable and programmable read-only memory semiconductor device included in a package having a window for receiving light comprising first and second MIS field effect transistors ($Q_1$, $Q_2$) connected in series between a power supply line ($V_{DD}$) and an earth line ($V_{SS}$); the second MIS field effect transistor arranged to receive a first input signal ($D_{in}$); third and fourth MIS field effect transistors ($Q_4$, $Q_5$) connected between the power supply line ($V_{DD}$) and the earth line ($V_{SS}$), the fourth MIS field effect transistor ($Q_5$) arranged to receive a second input signal ($P_{in}$); a capacitor (C) connected between the gate and source of the third MIS field effect transistor ($Q_4$); and a fifth MIS field effect transistor ($Q_3$) connected between first and second nodes ($P_1$, $P_2$), the first node ($P_1$) connecting the first and second MIS field effect transistors ($Q_1$, $Q_2$) and the second node ($P_2$) being connected to the gate of the third MIS transistor ($Q_4$) and to the capacitor (C) and hence coupled to the third and fourth MIS field effect transistors ($Q_4$, $Q_5$) and the output of the element, characterised in that the source or drain (5) of the fifth MIS field effect transistor ($Q_3$) which is connected to the second node ($P_2$) and hence is connected to the capacitor (C), is shielded by a cover (18, 18', 18'') which prevents light from reaching a p-n junction formed between the source or drain (5) and the substrate whilst allowing light to fall on other parts of the device.

2. A semiconductor element forming at least a part of a bootstrap circuit in an erasable and programmable read-only memory semiconductor device included in a package having a window for receiving light comprising a semiconductor substrate of a first conductivity type; first, second and third regions (4, 5, 7) of a second conductivity type formed in the substrate; a first insulating layer (21, CH3) formed on the substrate and arranged between the first and second regions (4, 5); a second insulating layer (21, CH6) formed on the substrate and arranged adjacent the third region (7); a first electrically conducting layer (11) formed on the first insulating layer (21, CH3) so that a MIS transistor ($Q_3$) is formed by the first electrically conducting layer (11), the first insulating layer and the first and second regions (4, 5); and a second electrically conducting layer (12) formed on the second insulating layer (21, CH6) so that a capacitor (C) is formed having a first surface provided by the second electrically conducting layer (12) and a second surface provided by the substrate adjacent the third region (7), the first and second surfaces being separated by the second insulating layer (21, CH6), and the second electrically conducting layer (12) being electrically connected to the second region (5), characterised in that an opaque layer (18, 18', 18'') is provided over the second region (5) to prevent light from penetrating into a junction formed between the second region (5) and the substrate whilst allowing light to fall on other parts of the device.

3. An element according to claim 2, in which the first and second insulating layers are formed by first and second portions of the same insulating layer (21).

4. An element according to claims 2 or 3, which also includes a third insulating layer (22) formed on the substrate and arranged between the second region (5) and the second insulating layer (21, CH6).

5. A semiconductor element according to claim 4, in which the second insulating layer (21, CH6) extends to the third insulating layer (22) and in which the opaque layer is formed by a third electrically conductive layer (18, 18', 18'') for connecting the second region (5) and the second electrically conducting layer 12.

6. An element according to claim 5, in which the third electrically conducting layer (18') extends into contact with the third insulating layer (22) at a contact region (C14 Figure 6B), the contact region (C14) being located outside the second region (5).

7. An element according to any one of claims 2 to 6, in which an insulating layer (22) is arranged between the first and second electrically conducting layers (11, 12) and the third electrically conducting layer (18, 18', 18'').

8. An element according to claim 4, or claims 5, 6 or 7, when dependent upon claim 4, in which a fourth insulating layer (21, CH7, Figure 9) is provided around the outside of the second region (5) and a fourth electrically conducting layer (31) is formed on the fourth insulating layer (21, CH7) and in that the third electrically conducting layer (18″) is connected to the fourth electrically conducting layer (31).

9. An element according to claim 8, in which a fifth electrically conducting layer (32 Figure 10) is formed on the third insulating layer (22) and is arranged around the outside of the second region (5).

10. An element according to any one of claims 2 to 9, in which the first and second layers and, where present, the fourth insulating layer (21, CH3, CH6, CH7) are made of a layer of thin silicon dioxide and the third insulating layer (22), where present, is made of a thick layer of silicon dioxide or phosphosilicate glass.

11. An element according to any one of claims 2 to 10, in which the electrically conducting material (11, 12, 31, 32) is made of polycrystalline silicon, molybdenum, tungsten or aluminium.

## Patentansprüche

1. Halbleiterelement, welches eine Bootstrap-Schaltung in einem löschbaren und programmierbaren Halbleiter-Nur-Lesespeicher umfaßt, der in einem Bauelement enthalten ist, das ein Fenster zum Empfang von Licht aufweist, mit ersten und zweiten MIS-Feldeffekttransistoren ($Q_1$, $Q_2$), die in Reihe zwischen einer Energieversorgungsleitung ($V_{DD}$) und einer Erdleitung ($V_{SS}$) geschaltet sind, wobei der zweite MIS-Feldeffekttransistor so angeordnet ist, daß er ein erstes Eingangssignal ($D_{in}$) empfängt, der dritte und vierte MIS-Feldeffekttransistor ($Q_4$, $Q_5$) zwischen der Energieversorgungsleitung ($V_{DD}$) und der Erdleitung ($V_{SS}$) geschaltet sind, der vierte MIS-Feldeffekttransistor ($Q_5$) so angeordnet ist, daß er ein zweites Eingangssignal ($P_{in}$) empfängt, ein Kondensator (C) zwischen Gate und Source des dritten MIS-Feldeffekttransistors ($Q_4$) geschaltet ist, und ein fünfter MIS-Feldeffekttransistor ($Q_3$) zwischen ersten und zweiten Verknüpfungspunkten ($P_1$, $P_2$) geschaltet ist, von denen der erste Verknüpfungspunkt ($P_1$) den ersten und den zweiten Feldeffekttransistor ($Q_1$, $Q_2$) miteinander verbindet und der zweite Verknüpfungspunkt ($P_2$) mit dem Gate des dritten MIS-Transistors ($Q_4$) und mit dem Kondensator (C) verbunden und somit mit den dritten und vierten MIS-Feldeffekttransistoren ($Q_4$, $Q_5$) und dem Ausgang des Elements verbunden ist, dadurch gekennzeichnet, daß Source oder Drain (5) des fünften MIS-Feldeffekttransistors ($Q_3$), der mit dem zweiten Verknüpfungspunkt ($P_2$) und somit mit dem Kondensator (C) verbunden ist, durch eine Abdeckung (18, 18′, 18″) abgeschirmt ist, welche verhindert, daß Licht zu einem p-n-Grenzbereich eindringt, welcher zwischen Source oder Drain (5) und dem Substrat gebildet ist, während sie erlaubt, daß Licht auf die anderen Teile der Vorrichtung fällt.

2. Halbleiterelement, welches wenigstens einen Teil einer Bootstrap-Schaltung in einem löschbaren und programmierbaren Halbleiter-Nur-Lese-Speicher bildet, der in einem Bauelement enthalten ist, das ein Fenster zum Empfang von Light aufweist, mit einem Halbleitersubstrat vom ersten Leitfähigkeitstyp, auf dem Substrat gebildete erste, zweite und dritte Bereiche (4, 5, 7) von einem zweiten Leitfähigkeitstyp, einer ersten isolierenden Schicht (21, CH3), die auf dem Substrat geformt und zwischen dem ersten und dem zweiten Bereich angeordnet ist, einer zweiten Isolierschicht (21, CH6), die auf dem Substrat gebildet und an den dritten Bereich angrenzend angeordnet ist, einer ersten elektrisch leitenden Schicht (11), die auf der ersten Isolierschicht (21, CH3) so gebildet ist, daß ein MIS-Transistor ($Q_3$) durch die erste elektrisch leitende Schicht (11), die erste Isolierschicht und den ersten und den zweiten Bereich (4, 5) gebildet ist, und mit einer zweiten elektrisch leitenden Schicht (12), die auf der zweiten Isolierschicht (21, CH6) so gebildet ist, daß ein Kondensator (C) gebildet wird, der eine erste Oberfläche hat, welche von der zweiten elektrisch leitenden Schicht gebildet ist, und eine zweite Oberfläche, die von dem Substrat nahe des dritten Bereichs (7) gebildet wird, wobei die erste und die zweite Oberfläche durch die zweite Isolierschicht (21, CH6) getrennt sind, und die zweite elektrisch leitende Schicht (12) elektrisch mit dem zweiten Bereich (5) verbunden ist, dadurch gekennzeichnet, daß eine lichtundurchlässige Schicht (18, 18′, 18″) über dem zweiten Bereich (5) vorgesehen ist, um zu verhindern, daß Licht in den Grenzbereich eindringt, der zwischen dem zweiten Bereich (5) und dem Substrat gebildet ist, während sie erlaubt, daß Licht auf die anderen Teile der Vorrichtung fällt.

3. Element nach Anspruch 2, bei welchem die erste und die zweite isolierende Schicht von ersten und zweiten Abschnitten derselben isolierenden Schicht (21) gebildet sind.

4. Element nach einem der Ansprüche 2 oder 3, welches eine dritte Isolierschicht (22) umfaßt, die auf dem Substrat ausgebildet und zwischen dem zweiten Bereich (5) und der zweiten Isolierschicht (21, CH6) angeordnet ist.

5. Halbleiterelement nach Anspruch 4, bei welchem die Zweite Isolierschicht (21, CH6) sich zu der dritten Isolierschicht (22) erstreckt und bei welcher die lichtundurchlässige Schicht durch eine dritte elektrisch leitende Schicht (18, 18′, 18″) gebildet ist, um den zweiten Bereich (5) und die zweite elektrisch leitende Schicht (12) zu verbinden.

6. Element nach Anspruch 5, bei welchem die dritte elektrisch leitende Schicht (18′) sich bei einem Kontaktbereich (C14 Figur 6B), welcher außerhalb des zweiten Bereichs (5) angeordnet ist, zum Kontakt mit der dritten isolierenden Schicht (22) erstreckt.

7. Element nach einem der Ansprüche 2 bis 6, bei welchem eine isolierende Schicht (22) zwischen den ersten und der zweiten elektrisch leitenden Schichten (11, 12) und der dritten elektrisch leitenden Schicht (18, 18', 18") angeordnet ist.

8. Element nach Anspruch 4 oder Ansprüchen 5, 6 oder 7, wenn auf Anspruch 4 rückbezogen, bei welchem eine vierte Isolierschicht (21, CH7, Figur 9) um die Außenseite des zweiten Bereichs (5) vorgesehen ist und eine vierte elektrisch leitende Schicht (31) auf der vierten Isolierschicht (21, CH7) gebildet ist, und dadurch gekennzeichnet, daß die dritte elektrisch leitende Schicht (18") mit der vierten elektrisch leitenden Schicht (31) verbunden ist.

9. Element nach Anspruch 8, bei welchem eine fünfte elektrisch leitende Schicht (32, Figur 10) auf der dritten Isolierschicht (22) gebildet und um die Außenseite des zweiten Bereichs (5) angeordnet ist.

10. Element nach einem der Ansprüche 2 bis 9, bei welchem die erste und die zweite Schicht und, wo vorhanden, die vierte Isolierschicht (21, CH3, CH6, CH7) aus einer Schicht aus dünnem Siliziumdioxid hergestellt sind und die dritte Isolierschicht (22), wo vorhanden, aus einer dicken Schicht aus Siliziumdioxid oder Phosphorsilikatglas hergestellt ist.

11. Element nach einem der Ansprüche 2 bis 10, bei welchem das elektrisch leitende Material (11, 12, 31, 32) aus polykristallinem Silizium, Molybdän, Wolfram oder Aluminium besteht.

## Revendications

1. Un élément semiconducteur formant un circuit de bootstrap dans un dispositif semiconducteur à mémoire morte programmable et effaçable incorporé dans un boîtier ayant une fenêtre destinée à recevoir de la lumière, comprenant des premier et second transistors à effet de champ MIS ($Q_1$, $Q_2$) connectés en série entre une ligne d'alimentation ($V_{DD}$) et une ligne de masse ($V_{SS}$); le second transistor à effet de champ MIS étant prévu de façon à recevoir un premier signal d'entrée ($D_e$); des troisième et quatrième transistors à effet de champ MIS ($Q_4$, $Q_5$) connectés entre la ligne d'alimentation ($V_{DD}$) et la ligne de masse ($V_{SS}$), le quatrième transistor à effet de champ MIS ($Q_5$) étant prévu de façon à recevoir un second signal d'entrée ($P_e$); un condensateur (C) connecté entre la grille et la source du troisième transistor à effet de champ MIS ($Q_4$); et un cinquième transistor à effet de champ MIS ($Q_3$) connecté entre des premier et second noeuds ($P_1$, $P_2$) le premier noeud ($P_1$) connectant les premier et second transistors à effet de champ MIS ($Q_1$, $Q_2$) et le second noeud ($P_2$) étant connecté à la grille du troisième transistor MIS ($Q_4$) et au condensateur (C) et donc connecté aux troisième et quatrième transistors à effet de champ MIS ($Q_4$, $Q_5$) et à la sortie de l'élément, caractérisé en ce que la source ou le drain (5) du cinquième transistor à effet de champ MIS ($Q_3$) qui est connecté au second noeud ($P_2$) et qui est donc connecté au condensateur (C), est masqué par un écran de recouvrement (18, 18', 18") qui empêche la lumière d'atteindre une jonction p-n formée entre la source ou le drain (5) et le substrat, tout en permettant à la lumière de tomber sur d'autres parties du dispositif.

2. Un élément semiconducteur formant au moins une partie d'un circuit bootstrap dans un dispositif semiconducteur à mémoire morte programmable et effaçable incorporé dans un boîtier ayant une fenêtre destinée à recevoir la lumière, comprenant un substrat semiconducteur d'un premier type de conductivité, des première, seconde et troisième régions (4, 5, 7) d'un second type de conductivité formées dans le substrat; une première couche isolante (21, CH3) formée sur le substrat et placée entre les première et seconde régions (4, 5); une seconde couche isolante (21, CH6) formée sur le substrat et placée en position adjacente à la troisième région (7); une première couche conductrice de l'électricité (11) formée sur la première couche isolante (21, CH3) de façon qu'un transistor MIS ($Q_3$) soit formé par la première couche conductrice de l'électricité (11), la première couche isolante et les première et seconde régions (4, 5); et une seconde couche conductrice de l'électricité (12) formée sur la seconde couche isolante (21, CH6), de façon à former un condensateur (C) ayant une première surface constituée par la seconde couche conductrice de l'électricité (12) et une seconde surface constituée par le substrat adjacent à la troisième région (7), les première et seconde surfaces étant séparées par la seconde couche isolante (21, CH6), et la seconde couche conductrice de l'électricité (12) étant connectée électriquement à la seconde région (5), caractérisé en ce qu'une couche opaque (18, 18', 18") est formée sur la seconde région (5) pour empêcher que la lumière ne pénètre dans une jonction formée entre la seconde région (5) et le substrat, tout en permettant à la lumière de tomber sur d'autres parties du dispositif.

3. Un élément selon la revendication 2, dans lequel les première et seconde couches isolantes sont formées par des première et seconde parties de la même couche isolante (21).

4. Un élément selon les revendications 2 ou 3, qui comprend également une troisième couche isolante (22) formée sur le substrat et placée entre la seconde région (5) et la seconde couche isolante (21, CH6).

5. Un élément semiconducteur selon la revendication 4, dans lequel la seconde couche isolante (21, CH6) s'étend jusqu'à la troisième couche isolante (22) et dans lequel la couche opaque est formée par une troisième couche conductrice de l'électricité (18, 18', 18") destinée à connecter la seconde région (5) et la seconde couche conductrice de l'électricité (12).

6. Un élément selon la revendication 5, dans lequel la troisième couche conductrice de l'électricité (18') vient en contact avec la troisième couche isolante (22) dans une région de contact (C14, figure 6B), et la région de contact (C14) se trouve à l'extérieur de la seconde région (5).

7. Un élément selon l'une quelconque des revendications 2 à 6, dans lequel une couche isolante (22) est placée entre les première et seconde couches conductrices de l'électricité (11, 12) et la troisième couche conductrice de l'électricité (18, 18', 18").

8. Un élément selon la revendication 4 ou les revendications 5, 6 ou 7, considérées comme dépendantes de la revendication 4, dans lequel une quatrième couche isolante (21, CH7, figure 9) est formé autour de la périphérie de la seconde région (5), et une quatrième couche conductrice de l'électricité (31) est formée sur la quatrième couche isolante (21, CH7), et dans lequel la troisième couche conductrice de l'électricité (18") est connectée à la quatrième couche conductrice de l'électricité (31).

9. Un élément selon la revendication 8, dans lequel une cinquième couche conductrice de l'électricité (32, figure 10) est formée sur la troisième couche isolante (22) et est placée autour de la périphérie de la seconde région (5).

10. Un élément selon l'une quelconque des revendications 2 à 9, dans lequel les première et seconde couches et, lorsqu'elle est présente, la quatrième couche isolante (21, CH3, CH6, CH7) sont constituées par une couche de dioxyde de silicium mince, et la troisième couche isolante (22), lorsqu'elle est présente, est constituée par une couche épaisse de dioxyde de silicium ou de verre au phosphosilicate.

11. Un élément selon l'une quelconque des revendications 2 à 10, dans lequel la matière conductrice de l'électricité (11, 12, 31, 32) consiste en silicium polycristallin, en molybdène, en tungstène ou en aluminium.

# Fig. 1

# Fig. 2

Fig. 3

0 011 975

# Fig. 4

22  12  C11  CH6  21  7  22  23

20  24

P

# Fig. 5

17  18  24

22  23  4  C6  23  CH3  C7  5  23  22  C9  12  CH4  21  22  23

21  11  P

## Fig. 6A

## Fig. 6B

Fig. 7

Fig. 8

Fig. 9

Fig. 10

*Fig. 11*

17  18  24

22  23  C6  4  CH3  21  23  5  23  32  22  12  CH4  21  22  23
N+        N+
21
11  C7  P

*Fig. 12*

18  24

23  32  22  C7  P  5  32  22  23
N+

0 011 975

8